# EUROPEAN PATENT SPECIFICATION

(11) **EP 4 691 215 B1**
(45) Date of publication and mention of the grant of the patent: **08.07.2026**
(21) Application number: 24827902.8
(22) Date of filing: 05.12.2024
(51) Int. Cl.: H10W 40/25, F28F 21/02

(54) **HEAT CONDUCTION ELEMENT FOR DISSIPATING THERMAL ENERGY FROM ELECTRONIC COMPONENTS**
WÄRMELEITELEMENT ZUR ABLEITUNG VON WÄRMEENERGIE ELEKTRONISCHER BAUTEILE
ÉLÉMENT DE CONDUCTION DE CHALEUR POUR DISSIPER L'ÉNERGIE THERMIQUE DE COMPOSANTS ÉLECTRONIQUES

(30) Priority: 06.12.2023 EP 23214553; 12.02.2024 IT 202400002935
(43) Date of publication of application: 11.02.2026
(73) Proprietor: Leonardo S.p.A., 00195 Roma (IT)
(72) Inventor: IMPICCICHÈ, Giuseppe, 00195 Roma (IT); IAZURLO, Romano Giovanni, 00195 Roma (IT); CARMINE, Emiliano, 00195 Roma (IT)
(74) Representative: Studio Torta S.p.A.
(86) International application number: PCT/IB2024/062254
(87) International publication number: WO 2025/120555

(56) References cited:
- CN-A- 113 954 448
- US-A- 6 131 651
- US-A1- 2020 307 158

## Description

### Field of the Art

The present invention relates to a heat-conduction element for dissipating thermal energy from electronic components. The present invention finds a preferred application in the space and defence sector, without thereby losing in generality.

### Background

As is known, the high performance of the electronic units and electro-optical components for space missions generally implies a high energy consumption, which necessarily translates into high temperatures for the electronic boards and for the space detectors.

In particular, in the space and defence sector there is a continuous effort to reduce the dimensions of the integrated circuits (ICs), which implies an increase in the heat sensitivity of the ICs themselves, also due to the deformations that the thin wafers could undergo.

In this regard, it should also be pointed out how the integrated circuits have long been designed to use new and very thin organic or inorganic dielectrics, which however have limited thermal stability, in some cases well below 200 °C.

Furthermore, the optical payloads for space applications may comprise very sensitive optical elements to be cooled even at cryogenic temperature.

From the above it can be immediately inferred how it is necessary to dissipate the heat generated by the electronic units and by the electro-optical components in order to safeguard the functionality thereof and guarantee the performance of the opto-mechanical system. In fact, the power electronic boards containing multiple energy-intensive components need to evacuate much of the heat dissipated to avoid problems on the welded interfaces and thus reducing hot spots on the board.

To keep the electronic components thermally stable during their operation, heat sinks are generally used, which, basically, consist of a mass of material to which the thermal energy of the component to be safeguarded is transferred. For the transfer of the thermal energy, the presence of a heat-conduction element constituting a conduction bridge between the component from which to remove the thermal energy and the heat sink can be provided. In these cases, heat dissipation involves the removal by conduction (thanks to the heat conduction element) from the high temperature region (component of interest to be safeguarded) to the heat sink, and the subsequent dissipation of the heat by convection from the surface of the heat sink to the surrounding atmosphere.

Generally, the heat-conduction elements are made of metal material, such as for example copper or aluminium. Such heat-conduction elements suffer from the disadvantage of being rigid and relatively heavy.

In fact, the rigidity of the heat-conduction element poses problems relative to the architecture of the electronic device as a whole, while the weight of the heat-conduction element is in stark contrast to the lightness required of the electronic devices, especially in the space field.

CN113954448A describes a heat conduction element consisting of a single thermoconductive graphite tape, folded and compacted several times on itself like an accordion and a pair of metal terminals, of which, in use, one is arranged in contact with the heat-producing body and one is arranged in contact with the heat sink body. Further, the heat-conduction element comprises a plurality of adhesive layers, each of which is housed between two overlapping portions of the folded tape.

Since the layers are not separated from each other but are portions of the same folded thermoconductive tape, it is possible to realize a heat conductivity both in the plane and in the vertical direction to the folded thermoconductive tape.

Such a solution entails that the graphite must necessarily be treated so that it can guarantee the accordion-like folding of the thermoconductive tape. In fact, graphite itself does not have the necessary elasticity to allow such a folding. Such treatment could also compromise the conductive capabilities of the material. Furthermore, the heat-conduction element of application CN113954448A provides that the folded tape is hot-pressed, and that the metal terminals are fixed by welding and riveting. All these operational steps represent a criticality, since if they are not carried out with due care and attention they can compromise the integrity of the thermal conductive tape and, therefore, its functionality as a heat conductor.

As it may be immediately apparent to a person skilled in the art, the solution described in application CN113954448A involves a series of operational interventions during the realization step, which necessarily represent a disadvantage in terms of operations.

It was, therefore, felt the need to have a heat conduction element, whose technical characteristics were able to give it a high flexibility and an extremely reduced weight.

### Disclosure of the Invention

The inventors of the present invention have realized a heat-conduction element based on a plurality of pyrolytic graphite sheets that guarantees a high heat conduction combined with a high flexibility and extremely low weight.

The object of the present invention is a heat conduction element between a heat-producing body and a heat sink; said heat conduction element comprising a central conduction portion, two connection ends and a multilayer structure extending both in the central conduction portion and in the two connection ends; each of said connection ends comprising a metal coating arranged to cover a respective longitudinal end of said multilayer structure and a metal terminal arranged to cover said metal coating; said heat conduction element being characterized in that said multilayer structure comprises a stack of pyrolytic graphite layers separated from each other and two layers of insulating polymeric material arranged on opposite sides with respect to said stack of pyrolytic graphite layers; in each of said connection ends a plurality of conduction holes are obtained that cross said multilayer structure and said metal coating and each have a diameter between 0.01 and 10 mm; each of said conduction holes being filled with conductive material.

Here and in the following, "conduction" means heat conduction even if not specified.

Preferably, glue is housed between two consecutive layers of said multilayer structure, and in correspondence with said connection ends.

Preferably, each of said pyrolytic graphite layers has a thickness of less than or equal to 0.1 **mm.**

Preferably, the pyrolytic graphite layers are between 2 and 200 in number.

Preferably, the metal coating is made of copper and said conductive material arranged inside said conduction holes is copper.

Preferably, the two layers of insulating polymeric material are made of polyimide.

Preferably, the multilayer structure comprises a pair of copper layers, each of which is arranged between a layer of insulating material and the stack of pyrolytic graphite layers.

Preferably, at least one through fixing hole is obtained in each of the connection ends.

### Brief Description of the Drawings

For a better understanding of the invention, an example of embodiment is given below for illustrative and nonlimiting purpose with the aid of the accompanying figures, wherein:
- Figure 1 is a perspective view from above of an embodiment of the heat-conduction element according to the present invention;
- Figure 2 is a perspective view of the heat-conduction element of Figure 1 but in another configuration;
- Figure 3 is a longitudinal section in schematic form with parts removed for clarity's sake.

### Preferred Embodiment of the Invention

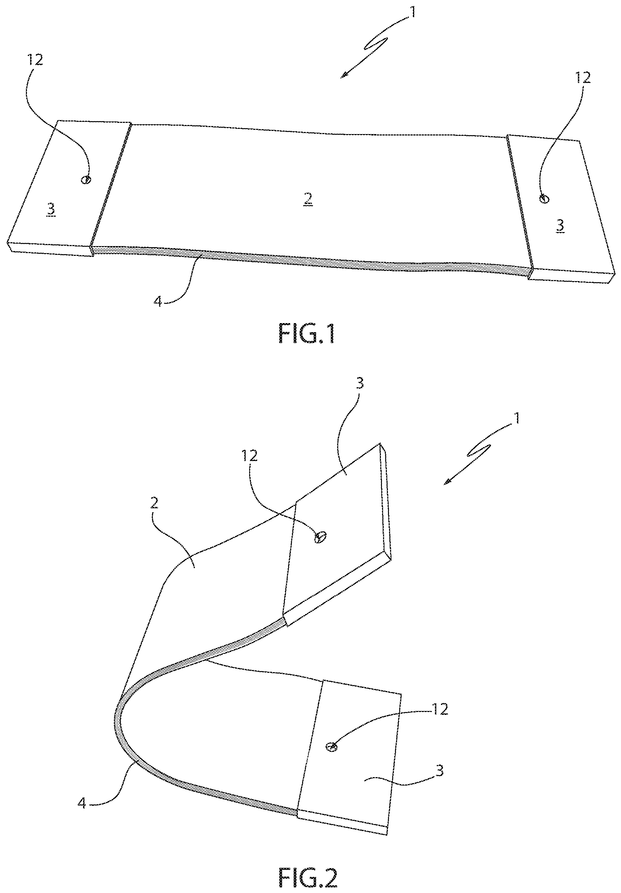

In Figures 1 and 2, 1 denotes as a whole an embodiment of the heat-conduction element according to the present invention.

The heat conduction element 1 substantially comprises a central conduction portion 2 and two connection ends 3.

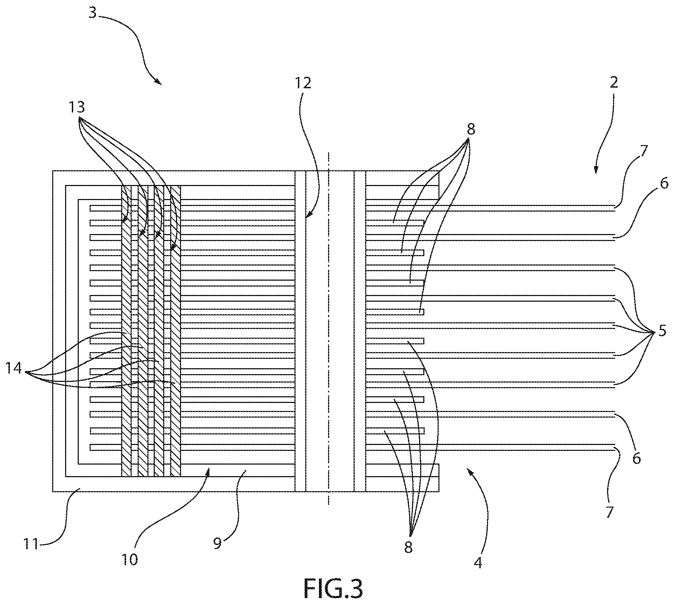

As shown in Figure 3, the heat-conduction element 1 comprises a multilayer structure 4 that extends both in the central conduction portion 2 and in the two connection ends 3.

As shown in Figure 3, the multilayer structure 4 comprises a plurality of pyrolytic graphite layers 5 of thickness equal to 0.08 mm, two layers of copper 6 arranged on opposite sides of the stack of pyrolytic graphite layers 5 and two insulating layers 7 of thickness equal to 0.025 mm arranged externally to the two layers of copper 6.

Each of the two insulating layers 7 is made of polymeric material, preferably polyimide, such as for example Kapton^{®}.

The two layers of Kapton^{®} have a protective function, imparting the necessary mechanical strength to the multilayer structure 4 as a whole without, however, compromising its flexibility. In particular, a configuration of the heat-conduction element 1 showing its flexibility is shown in Figure 2.

As shown in Figure 3, glue in the form of adhesive layers 8 is housed between two consecutive layers of the multilayer structure 4 and in correspondence with the connection ends 3.

Each of the connection ends 3 comprises a thermally conductive metal coating 9, arranged to cover a longitudinal end 10 of the multilayer structure 4, and a metal terminal 11 arranged to cover the thermally conductive coating 9.

The thermally conductive coating is made of copper and has a thickness of about 0.1 mm.

The metal terminal 11 is made of thermally conductive material, preferably copper or aluminium, and has a thickness greater than or equal to 3 mm.

In use, the metal terminals 11 are in contact respectively with a heat-producing body and a heat sink.

At least one fixing hole 12 is obtained in each of the connection ends 3. As is apparent from Figure 3, the fixing hole 12 crosses the entire connection end 3 (the longitudinal end 10 of the multilayer structure 4, the thermally conductive coating 9 and the metal terminal 11). In use, the fixing holes 12 are engaged, for example, by a bolt and fixed to the heat-producing body or to the heat sink. As may be immediately apparent to a person skilled in the art, the metal terminal 11 also has a protective function. In fact, in the absence of the metal terminal 11 the fixing of the connection end 3 to the heat-producing body or to the heat sink could compromise the integrity of the pyrolytic graphite layers.

Each of the fixing holes 12 has a diameter of about 3.2 mm. Obviously, the dimensions of the hole can also be greater if the bolt to be used has a greater diameter, for example 4.3 and 5.3 mm.

In each of the connection ends 3 a plurality of conduction holes 13 are obtained, each of which crosses the longitudinal end 10 of the multilayer structure 4 and the thermally conductive coating 9. The conduction holes 13, therefore, do not cross the metal terminal 11 with which they are covered as can be seen in Figures 1 and 2.

Each of the conduction holes 13 is filled with conductive material, preferably copper, indicated with 14 in Figure 3.

The role of the conduction holes 13 is to guarantee out-of-plane conduction. In fact, while the multilayer structure 4, comprising pyrolytic graphite layers separated from each other, guarantees an in-plane heat conduction, in the absence of the conduction holes 13 filled with thermally conductive material 14 the possibility of having an out-of-plane conduction would be strongly limited, if not compromised.

Conversely, the conduction holes 13 and the conductive material 14, contained therein, guarantee the out-of-plane heat conduction and its conversion into the in-plane heat conduction and vice versa.

In particular, the conduction holes 13 can be filled with copper once the longitudinal end 10 of the multilayer structure 4 is brazed with copper for coupling with the metal terminal 11.

In fact, brazing is used to assemble the metal terminals 11 to the longitudinal ends of the multilayer structure **4.** This means that the longitudinal end 10 of the multilayer structure 4 must be subjected to a surface treatment suitable for chemical compatibility and adhesion of the brazing material (coating 9). Typically, a copper-finished surface obtained by chemical deposition is compatible with the most common chemical brazing process. In addition, since graphite has an excellent in-plane but not out-of-plane conductance, the deposition of copper creates a conductive layer that covers the outer faces of each end of the multilayer structure representing an improvement for the conduction of heat from the interface to the graphite foils.

As described above, at each end of the multilayer structure optimization of the out-of-plane heat conduction is achieved by means of the small conduction holes 13. Once the metal terminal 11 has been brazed, the conduction hole is filled with a metal column (preferably copper) which guarantees an improvement in the out-of-plane heat conduction, thus increasing the total thermal performance of the heat conduction element as a whole.

A first heat conduction element 1 with five pyrolytic graphite layers was tested under vacuum conditions to characterize the thermal performance. The measured thermal conductance is equal to 0.11 W/K ± 0.01 W/K in accordance with the ECSS-E-HB-31-01 and ECSS-E-10-03A Space standards.

Another heat conduction element 1 was tested which differs from the previous one in that it comprises thirty layers of graphite instead of five. Under the same test conditions used for the previous heat-conduction element, a thermal conductance equal to 0.55 W/K ± 0.01 W/K was detected.

From the above it is evident that the heat-conduction element according to the present invention has important advantages especially in terms of thermal conductivity and flexibility.

In particular, it should be highlighted how the present technical solution manages to exploit the conductivity of pyrolytic graphite in a flexible structure despite the fact that pyrolytic graphite itself has low flexibility.

As mentioned above, in light of the complex architectures of the electronic devices intended, for example, for space, aeronautical and helicopter applications, flexibility and lightness are extremely relevant characteristics for this type of heat conduction elements and represent an important added value.

## Claims

1. Heat conduction element (1) between a heat-producing body and a heat sink; said heat conduction element comprising a central conduction portion (2), two connection ends (3) and a multilayer structure (4) extending both in the central conduction portion (2) and in the two connection ends (3); each of said connection ends (3) comprising a metal coating (9) arranged to cover a respective longitudinal end (10) of said multilayer structure (4) and a metal terminal (11) arranged to cover said metal coating (9); said heat conduction element being **characterized in that** said multilayer structure (4) comprises a stack of pyrolytic graphite layers (5) separated from each other and two layers of insulating polymeric material (7) arranged on opposite sides with respect to said stack of pyrolytic graphite layers (5); in each of said connection ends (3) a plurality of conduction holes (13) are obtained that cross said multilayer structure (4) and said metal coating and each have a diameter between 0.01 and 10 mm; each of said conduction holes (13) being filled with conductive material (14).

2. Heat conduction element according to claim 1, **characterized in that** glue (8) is housed between two consecutive layers of said multilayer structure, and in correspondence with said connection ends (4).

3. Heat conduction element according to claim 1 or 2, **characterized in that** each of said pyrolytic graphite layers (5) has a thickness less than or equal to 0.1 mm.

4. Heat conduction element according to one of the preceding claims, **characterized in that** the pyrolytic graphite layers are between 2 and 200 in number.

5. Heat conduction element according to one of the preceding claims, **characterized in that** said metal coating (9) is made of copper and said conductive material (14) arranged inside said conduction holes (13) is copper.

6. Heat conduction element according to one of the preceding claims, **characterized in that** the two layers of insulating polymeric material (7) are made of polyimide.

7. Heat conduction element according to one of the preceding claims, **characterized in that** said multilayer structure (4) comprises a pair of copper layers (6), each of which is arranged between a layer of insulating material (7) and the stack of pyrolytic graphite layers (5).

8. Heat dissipation element according to one of the preceding claims, **characterized in that** at least one fixing through hole (12) is obtained in each of the connection ends (3).

## Patentansprüche

1. Wärmeleitelement (1) zwischen einem wärmeerzeugenden Körper und einer Wärmesenke,
wobei das Wärmeleitelement einen mittigen Leitungsabschnitt (2), zwei Verbindungsenden (3) und eine mehrschichtige Struktur (4) aufweist, die sich sowohl im mittigen Leitungsabschnitt (2) als auch in den beiden Verbindungsenden (3) erstreckt, wobei jedes der Verbindungsenden (3) eine Metallbeschichtung (9), die derart angeordnet ist, dass sie ein jeweiliges Längsende (10) der mehrschichtigen Struktur (4) bedeckt, sowie einen Metallanschluss (11) aufweist, der derart angeordnet ist, dass er die Metallbeschichtung (9) bedeckt,
wobei das Wärmeleitelement **dadurch gekennzeichnet ist, dass**
die mehrschichtige Struktur (4) einen Stapel aus voneinander getrennten Schichten aus pyrolytischem Graphit (5) und zwei Schichten aus einem isolierenden Polymermaterial (7) aufweist, die auf gegenüberliegenden Seiten in Bezug auf den Schichtstapel aus pyrolytischem Graphit angeordnet sind;
in jedem der Verbindungsenden (3) eine Vielzahl von Leitungslöchern (13) ausgebildet sind, die die mehrschichtige Struktur (4) und die Metallbeschichtung durchqueren und jeweils einen Durchmesser zwischen 0,01 und 10 mm aufweisen, wobei jedes der Leitungslöcher (13) mit einem leitfähigen Material (14) gefüllt ist.

2. Wärmeleitelement nach Anspruch 1, **dadurch gekennzeichnet, dass** ein Klebstoff (8) zwischen zwei aufeinanderfolgenden Schichten der mehrschichtigen Struktur und in Übereinstimmung mit den Verbindungsenden (4) angeordnet ist.

3. Wärmeleitelement nach Anspruch 1 oder 2, **dadurch gekennzeichnet, dass** jede der Schichten aus pyrolytischem Graphit (5) eine Dicke von höchstens 0,1 mm aufweist.

4. Wärmeleitelement nach einem der vorangehenden Ansprüche, **dadurch gekennzeichnet, dass** die Anzahl der Schichten aus pyrolytischem Graphit zwischen 2 und 200 beträgt.

5. Wärmeleitelement nach einem der vorangehenden Ansprüche, **dadurch gekennzeichnet, dass** die Metallbeschichtung (9) aus Kupfer besteht und das in den Leitungslöchern (13) angeordnete leitfähige Material (14) Kupfer ist.

6. Wärmeleitelement nach einem der vorangehenden Ansprüche, **dadurch gekennzeichnet, dass** die beiden Schichten aus isolierendem Polymermaterial (7) aus Polyimid hergstellt sind.

7. Wärmeleitelement nach einem der vorangehenden Ansprüche, **dadurch gekennzeichnet, dass** die mehrschichtige Struktur (4) ein Paar Kupferschichten (6) aufweist, von denen jede zwischen einer Schicht aus isolierendem Material (7) und dem Schichtstapel aus pyrolytischem Graphit (5) angeordnet ist.

8. Wärmeleitelement nach einem der vorangehenden Ansprüche, **dadurch gekennzeichnet, dass** in jedem der Verbindungsenden (3) mindestens ein durchgehendes Fixierloch (12) ausgebildet ist.

## Revendications

1. Élément de conduction thermique (1) entre un corps producteur de chaleur et un dissipateur de chaleur ; ledit élément de conduction thermique comprenant une partie centrale de conduction (2), deux extrémités de connexion (3) et une structure multicouche (4) s'étendant à la fois dans la partie centrale de conduction (2) et dans les deux extrémités de connexion (3) ; chacune desdites extrémités de connexion (3) comprenant un revêtement métallique (9) agencé pour recouvrir une extrémité longitudinale respective (10) de ladite structure multicouche (4) et une borne métallique (11) agencée pour recouvrir ledit revêtement métallique (9) ; ledit élément de conduction thermique étant **caractérisé en ce que** ladite structure multicouche (4) comprend un empilement de couches de graphite pyrolytique (5) séparées les unes des autres et deux couches de matériau polymère isolant (7) agencées sur des côtés opposés par rapport audit empilement de couches de graphite pyrolytique (5) ; dans chacune desdites extrémités de connexion (3), une pluralité de trous de conduction (13) sont obtenus qui traversent ladite structure multicouche (4) et ledit revêtement métallique et qui ont chacun un diamètre compris entre 0,01 et 10 mm ; chacun desdits trous de conduction (13) étant rempli de matériau conducteur (14).

2. Élément de conduction thermique selon la revendication 1, **caractérisé en ce que** de la colle (8) est logée entre deux couches consécutives de ladite structure multicouche, et en correspondance avec lesdites extrémités de connexion (4).

3. Élément de conduction thermique selon la revendication 1 ou 2, **caractérisé en ce que** chacune desdites couches de graphite pyrolytique (5) présente une épaisseur inférieure ou égale à 0,1 mm.

4. Élément de conduction thermique selon l'une des revendications précédentes, **caractérisé en ce que** les couches de graphite pyrolytique sont comprises entre 2 et 200 en nombre.

5. Élément de conduction thermique selon l'une des revendications précédentes, **caractérisé en ce que** ledit revêtement métallique (9) est constitué de cuivre et ledit matériau conducteur (14) agencé à l'intérieur desdits trous de conduction (13) est du cuivre.

6. Élément de conduction thermique selon l'une des revendications précédentes, **caractérisé en ce que** les deux couches de matériau polymère isolant (7) sont constituées de polyimide.

7. Élément de conduction thermique selon l'une des revendications précédentes, **caractérisé en ce que** ladite structure multicouche (4) comprend une paire de couches de cuivre (6), chacune étant agencée entre une couche de matériau isolant (7) et l'empilement de couches de graphite pyrolytique (5).

8. Élément de dissipation thermique selon l'une des revendications précédentes, **caractérisé en ce qu'**au moins un trou traversant de fixation (12) est obtenu dans chacune des extrémités de connexion (3).
